# EUROPÄISCHE PATENTSCHRIFT

(11) **EP 0 863 695 B1**
(45) Veröffentlichungstag und Bekanntmachung des Hinweises auf die Patenterteilung: **25.10.2000**
(21) Anmeldenummer: 98101580.3
(22) Anmeldetag: 30.01.1998
(51) Int. Cl.: H05K 7/20

(54) **Gerätegehäuse**
Apparatus housing
Boîtier d'appareillage

(30) Priorität: 08.03.1997 DE 29704237 U
(43) Veröffentlichungstag der Anmeldung: 09.09.1998
(73) Patentinhaber: DMT GmbH Feinwerktechnische Komplettlösungen, 71034 Böblingen (DE)
(72) Erfinder: Kopp, Siegfried, 71272 Renningen (DE); Häberle, Jürgen, 71032 Böblingen (DE); Schwegler, Tim, 71069 Sindefingen (DE)
(74) Vertreter: Rudolph, Wolfgang

(56) Entgegenhaltungen:
- EP-A- 0 456 398
- EP-A- 0 546 211
- EP-A- 0 617 570
- US-A- 4 587 593
- US-A- 4 739 445
- US-A- 5 297 004

## Beschreibung

Die Erfindung betrifft ein Gerätegehäuse nach dem Oberbegriff des Patentanspruches 1.

Gerätechassis für elektronische Geräte, Meßgeräte und feinmechanische Geräte sind grundsätzlich bekannt. Sie nehmen die Komponenten des Gerätes auf, die auf einem derartigen Chassis montiert werden. Die Komponenten sind je nach Art des Gerätes entweder Leiterplatten, Speicherplatten, Ventilatoren, Lautsprecher, Kühlvorrichtungen, Pumpen, Getriebe u.s.w.. Das Chassis hat den Zweck, die einzelnen Komponenten innerhalb des Gerätes mechanisch in einer bestimmten Position zu fixieren. Ein derartiges Chassis umfaßt normalerweise einen Rahmen mit mehreren Unterteilungen, in denen die Komponenten befestigt werden. Der Rahmen selbst wird an einem äußeren Gehäuse des jeweiligen Gerätes befestigt.

Es ist auch bekannt, Teile aus hartem Kunststoff für ein Chassis zu verwenden, wobei die Montage wie beim Metallchassis kompliziert und zeitaufwendig ist, da Befestigungselemente, wie Schrauben, Nieten, Bänder und Haltevorrichtungen erforderlich sind. Außerdem müssen elektromagnetische Abschirmvorrichtungen vorgesehen werden, in dem Kunststoffteile mit dem leitfähigen Material abgedeckt werden und/oder in dem Metallplatten oder -folien an dem Chassis befestigt werden. Derartige Chassis sind mechanisch zu kompliziert aufgebaut und die Montage sowie das Anbringen von Komponenten ist zu teuer.

Um diese Nachteile zu beseitigen, wird in dem Deutschen Gebrauchsmuster 9116755.8 ein Chassis eines Gerätes, beispielsweise eines Computers oder elektronischen Meßgerätes beschrieben, das mehrere, das Gerät bildende Komponenten, zum Beispiel Leiterplatten, Speicherplatten, Ventilatoren u.s.w. hält, das durch eine Trägereinheit aus Kunststoff, die Aussparungen aufweist, die jeweils an die äußeren Formgebungen der Komponenten angepaßt sind, wobei die Komponenten in der Trägereinheit in einer im wesentlichen formschlüssigen Weise gehalten sind, ohne daß Befestigungselemente benötigt werden und von der Trägereinheit umschlossen werden, wenn sie hierin eingesetzt sind. Das Chassis weist eine Trägereinheit auf, die aus einem unteren Teil, in das die Komponenten eingesetzt werden können, wenn das Chassis zusammengebaut wird, und einem oberen Teil für die paßgenaue Abdeckung des unteren Teils mit den eingesetzten Komponenten besteht. Das obere und das untere Teil sind miteinander entlang einer Kante beweglich verbunden, so daß das obere Teil für einen Zugriff auf die in dem unteren Teil eingesetzten Komponenten hochgeschwenkt werden kann. Die Trägereinheit weist Lüftungskanäle auf, die in dem Kunststoff ausgeformt sind, wobei ein Ventilator in einem Lüftungskanal so angeordnet ist, daß der von dem Ventilator erzeugte Luftstrom über Komponenten führt, die zu kühlen sind. Das Chassis kann auch so ausgestaltet sein, daß Aussparungen in unterschiedlichen Ebenen ausgebildet sind, wobei eine Ebene oberhalb der anderen angeordnet ist, so daß Komponenten übereinander angeordnet werden können. Das Chassis besteht aus einem Kunststoff, der eine Dichte von annähernd 60 bis 80 g/l hat. Als sehr vorteilhafter Kunststoff hat sich expandierendes Polypropylen bei der Realisierung herausgestellt. Polypropylen ist ein leichtes Material, kann leicht in unterschiedliche Formen formgepreßt werden, ist stoßabsorbierend, elastisch, weist ein inhärentes Rückstellverhalten auf, ist darüberhinaus deformierbar und nachgebend und weist dennoch eine hohe Formstabilität auf. Weiterhin ist Polypropylen temperaturstabil und chemisch resistent. Es kann vollständig wiederverwertet werden und ist somit vom Gesichtspunkt des Umweltschutzes her sehr vorteilhaft. Es sind jedoch auch ähnliche Materialien wie Polyurethan und Polyäthylen und ähnliche Kunststoffe für das Chassis verwendbar. Das obengenannte Chassis benötigt jedoch immer ein komplettes Gehäuse aus Metall oder aus einem metallisierten Kunststoff des jeweiligen Gerätes. Dabei hat es sich als vorteilhaft herausgestellt, wenn das Chassis von einer Metalleinfassung umgeben ist, die an ihrer Vorderseite und an ihrer Rückseite offen ist, so daß das Chassis in die Einfassung durch eine dieser Öffnungen eingesetzt werden kann. Eine vordere und eine hintere Abschirmplatte, die typischerweise aus Metall gefertigt sind, bedecken die vorderen bzw. hinteren Flächen eines solchen Chassis.

Der Erfindung liegt die Aufgabe zugrunde, ein Gerätegehäuse zu schaffen, das aus einem Chassis oder Komponententräger aus wiederverwertbarem Kunststoff mit Aussparungen für Komponenten, die im wesentlichen in formschlüssiger Weise gehalten werden, besteht, das in bereits vorhandene Kästen oder dergleichen von Labor,- Büro-, Werkstatt- und Heimmöbel oder dergleichen einsetzbar gestaltet ist, wobei das Chassis mit dem bereits vorhandenen Kasten, wie zum Beispiel einem Kasten eines Schreibtisches, eine integrale und funktionale Einheit bilden soll.

Die erfindungsgemäße Lösung ist in den Kennzeichen der Patentansprüche 1 und 2 charakterisiert.

Weitere Ausgestaltungen bzw. Lösungen der Aufgabe sind in den Patentansprüchen 3 bis 20 charakterisiert.

Das Gerätegehäuse besteht aus einem Kunststoff-, insbesondere Schaumstoffchassis bzw. -träger, zur Aufnahme der Gerätekomponenten und einem Kasten bzw. einer Schublade aus Metall oder mit einer Metallschicht, einem Metallblech oder einer Metallfolie ausgekleidet, eines Möbels, wie zum Beispiel eines Schreibtisches oder eines Schrankes bzw. Schrankteils, wobei das Kunststoff- bzw. Schaumstoffchassis mit elastischen Ohren ausgestattet ist, die als Halte/Klemmvorrichtungen dienen und deren Zwischenräume in Verbindung mit dem Metallkasten oder dergleichen einstellbare bzw. steuerbare Luftkanäle bilden, die durch einsteckbare, einschiebbare oder verschiebbare Kunststoffteile ein leicht anpassbares Lüftungssystem für die jeweiligen Komponenten ermöglichen. Dadurch können zum Beispiel Computer, Meßgeräte, Laborgeräte, Multimediageräte oder dergleichen im Kasten eines Schreibtisches oder eines Labortisches bzw. in einem Einschub bzw. einer Schublade eines sonstigen Möbelstückes untergebracht werden, wobei der jeweilige Kasten bzw. Einschub und das Kunststoffchassis eine integrale und funktionale Geräteeinheit und damit das eigentliche Gerätegehäuse mit Lüftungssystem bilden. Durch die Zusammenfassung einer bereits vorhandenen Schublade bzw. eines Einschubes oder eines Kastens eines Möbelstückes mit dem ganz besonders gestalteten Kunststoffchassis, wobei der Kasten entweder ein Metallkasten ist oder mit einer Metallschicht versehen ist oder mit einer Folie ausgeschlagen ist, wird erstmals der Einschub, die Schublade bzw. der herausziehbare und einschiebbare Kasten eines Möbelstückes zum Gerätegehäuse selbst. Die Montage und die Funktionstüchtigkeit ist durch die spezielle Gestaltung des Kunststoffchassis in hervorragender Weise gegeben, ohne daß das sonst immer erforderliche Metallgehäuse oder metallisierte Kunststoffgehäuse für ein Gerät erforderlich ist. Dies wird dadurch erreicht, daß der jeweilige Kasten und das eingesetzte Kunststoffchassis eine integrale Funktionseinheit mit einem Lüftungssystem mit speziell ausgebildeten steuerbaren Lüftungskanälen und Luftein- und -auslässen bildet. Außerdem ist durch die Verwendung einer speziell für diese Konstruktion gestaltete Übergabeplatine für die elektrischen Verbindungen zur Außenwelt eine technische Lösung gefunden worden, die die Funktionssicherheit des Gerätes gewährleistet und dem vorliegenden neuartigen Gerätegehäuse angepaßt ist.

Die vorliegende Erfindung bringt neben anderen die folgenden zusätzlichen Vorteile:

Die Anzahl der Teile, die das Chassis und auch das gesamte Gerätegehäuse bilden, ist erheblich verringert worden, die Anforderungen hinsichtlich der Fertigungstoleranzen sind kleiner als bei einem Chassis aus Metall oder hartem Kunststoff nach dem Stand der Technik, bei dem zusammenzubauende Teile mit großer Präzision hergestellt werden müssen, um ein genaues Zusammenpassen der verschiedenen Teile sicherzustellen. Die Komponenten können in das Chassis leicht eingesetzt werden und werden ohne zusätzliche Haltematerialen darin festgehalten und das Chassis ist wiederum sehr leicht in einen vorhandenen Kasten mit entsprechenden Durchbrüchen, bedingt durch das Vorhandensein der elastischen Ohren sehr leicht einsetzbar.
- Das Gewicht ist wesentlich gegenüber den bisher bekanntgewordenen Konstruktionen verringert worden;
- es wird eine sehr gute akustische Dämmung, eine sehr gute elektrische Abschirmung und durch die Luftführungskanäle eine sehr wirksame Kühlung der Komponenten verwirklicht;
- die Komponenten sind durch die Eigenschaften des Chassismaterials stoßabsorbierend angeordnet. Aufgrund der stoßabsorbierenden Funktion des Chassis sind die Anforderungen hinsichtlich der stoßgeschützten Verpackung des Gerätes während eines Transports verringert. Verpackungsmaterial und Transportvolumen werden dadurch auch wesentlich verringert;
- die Demontage ist so problemlos und einfach wie die Montage, was für die Wartung der Geräte vorteilhaft ist und außerdem auch im Falle der Geräterücknahme durch Hersteller.

Es soll hier betont sein, daß der Erfindungsgegenstand nicht auf elektronische oder feinmechanische Geräte wie Computer oder Meßinstrumente beschränkt ist, sondern für alle Arten von Geräten verwendet werden kann, bei dem mehrere Komponenten vorgesehen sind, die an einer festen Position zu halten sind und in Möbelstücken jeder Art untergebracht werden müssen.

Weitere Merkmale der Erfindung ergeben sich aus der nachfolgenden Beschreibung und der Zeichnung.

Die Erfindung wird nun anhand von in der Zeichnung dargestellten Ausführungsbeispielen näher erklärt. In der Beschreibung, in den Patentansprüchen und in den Figuren werden für gleiche Teile die in der hinten angegebenen Liste der Bezugszeichen aufgeführten Bezugszeichen und Begriffe verwendet.

Die Erfindung wird nun anhand von in der Zeichnung dargestellten Ausführungsbeispielen näher erklärt. In der Zeichnung bedeuten:
- Fig. 1: ein Gerätegehäuse in Explosivdarstellung;
- Fig. 2: eine detailliertere Darstellung eines Gerätegehäuses mit teilweise auseinandergezogener Darstellung bestimmter Teile bzw. Komponenten;
- Fig. 3: ein Gerätegehäuse in Form eines Schubkastens aus Metall für einen Schreibtisch;
- Fig. 4: die Vorderansicht eines Büromöbels mit eingeschobenem Schubkasten als Gerätegehäuse und
- Fig. 5: ein Möbelstück mit eingeschobenem Schubkasten als Gerätegehäuse von hinten gesehen.

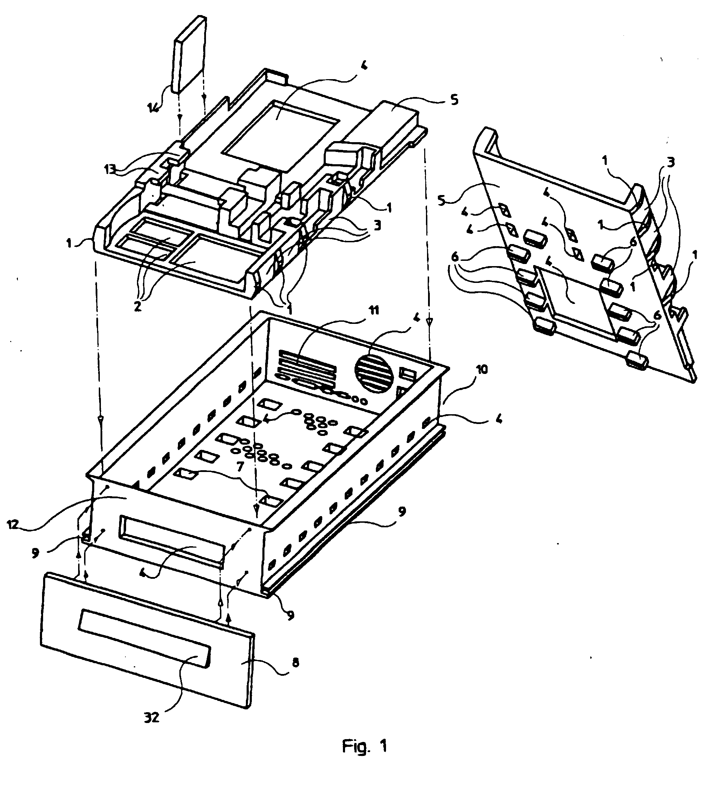

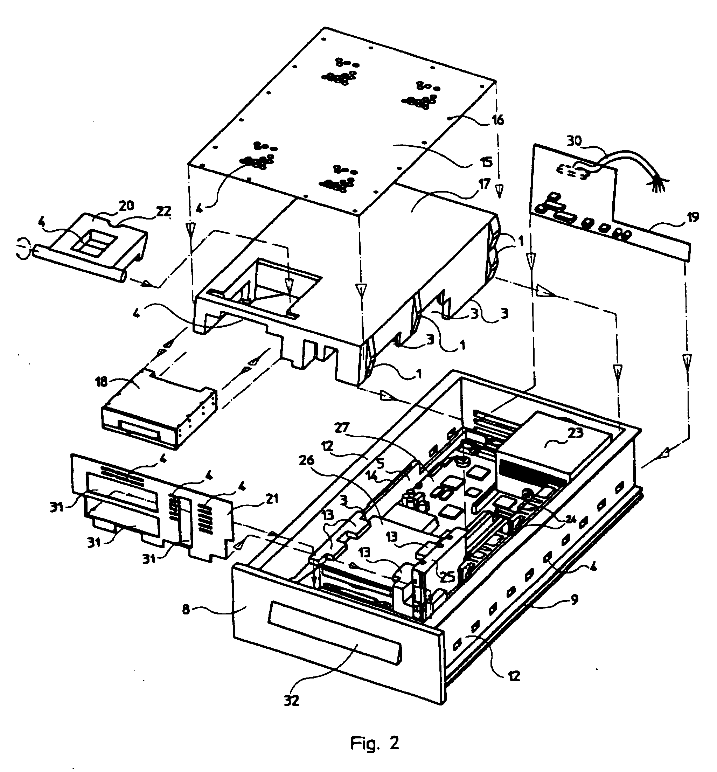

In Fig. 1 ist eine Schublade bzw. ein Schubkasten 12 perspektivisch dargestellt. Der Schubkasten 12 besteht in diesem Fall aus Metall und ist Teil zum Beispiel eines Schreibtisches in dem zum Beispiel die gesamte Computerelektronik oder die Elektronik für ein Meßgerät untergebracht ist. Die Schublade bzw. der Schubkasten 12 kann entweder völlig aus Metall hergestellt sein, oder aus Holz bzw. Kunststoff, wobei zu beachten ist, daß zur elektrischen Abschirmung ein derartig ausgeführter Schubkasten 12 mit einer Metallfolie bzw. mit einer Metallschicht oder einem dünnen Metallblech ausgekleidet sein muß. Die Abschirmung kann auch dadurch erreicht werden, daß die Chassisteile bzw. Komponententräger 5 und 17 in Metallfolie oder metallisierte Kunststoffolie mit Lüftungsöffnungen 4 eingewickelt werden. Der Schubkasten bzw. die Schublade 12 hat in diesem Ausführungsbeispiel an allen vier Wänden und dem Boden Lufteinlaß-/auslaßöffnungen 4. Diese Lufteinlaß-/auslaßöffnungen 4 können je nach Erfordernis die unterschiedlichsten Formen und Größen aufweisen wie klar aus der Fig. 1 zu ersehen ist. Außerdem besitzt der Schubkasten 12 am Boden Arretierungslöcher oder -einbuchtungen 7, in die entsprechende Arretierungsdome und Abstandshalter 6 des Unterteils 5 des Schaumstoffchassis passen. Diese haben zum einen die Aufgabe das Chassisunterteil 5 im Schubkasten bzw. in der Schublade 12 eindeutig zu arretieren und festzuhalten, damit dieses mit dem Schubkasten bzw. der Schublade 12 eine integrale Einheit bildet und zum anderen dienen sie zur Fixierung eines definierten Abstandes zwischen dem eingesetzten Unterteil 5 des Chassis zur Bodenplatte der Schublade bzw. des Schubkastens 12, um definierte Lüftungskanäle bilden zu können. Am Unterteil 5 des Chassis sind außerdem an beiden Seiten sogenannte Ohren 1 als integraler Bestandteil des Kunststoffchassis ausgebildet. Diese Ohren 1 dienen unter anderem zum Toleranzausgleich beim Einsetzen des Unterteils 5 in die Schublade bzw. den Schubkasten 12, damit diese beiden Teile integrale Bestandteile des Gerätegehäuses bilden. Dadurch, daß in den Wänden auf beiden Seiten der Schublade bzw. des Schubkastens 12 Lufteinlaß-/auslaßöffnungen 4 vorhanden sind und zwischen den leicht klemmenden Ohren 1 ein Zwischenraum vorhanden ist, werden Luftführungskanäle 3 gebildet, die je nach gewünschter Luftführung entsprechend ausgeformt werden können. Durch einschiebbare oder einsteckbare oder verschiebbare Teile 14, die als Schaumstoffüller zur Luftstromsteuerung in die Luftführungskanäle 3 zwischen die Ohren 1 modular einsetzbar sind, entstehen steuerbare bzw. gesteuerte Luftkanäle, womit auf einfachste Art und Weise für bestimmte Komponenten die Durchflußmenge und auch die Geschwindigkeit der Kühlluft bzw. der Abluft bestimmt werden kann. Das dargestellte Unterteil 5 des Chassis nach Fig. 1 besitzt außerdem noch integrierte Auflagen bzw. Niederhalter 13 für einzubringende Laufwerke oder ähnliches, zum Beispiel für erforderliche Informationsspeicher. In Fig. 1 ist der Schubkasten bzw. die Schublade 12 so räumlich dargestellt, daß auch die Führungsschienen 9 auf beiden Seiten deutlich zu sehen sind. Außerdem besitzt die Schublade bzw. der Schubkasten 12 normalerweise eine Frontplatte 8, die die Lufteinlaß-/auslaßöffnung 4 abdeckt, wobei in dieser Frontplatte 8 ein Griff so geformt ist, daß er zum Beispiel einen Lufteinlaß für diese darunterliegende Öffnung 4 bildet. An der Hinterseite des Schubkastens bzw. der Schublade 12 ist ein Steckkarteneinschub 11 für die elektrischen Anschlüsse angeordnet, der im Zusammenhang mit Fig. 2 noch näher erklärt wird.

In Fig. 2 ist der Schubkasten bzw. die Schublade 12 mit eingesetztem Unterteil 5 des Chassis zu sehen, in das eine Leiterplatte 27 mit Bauteilen, ein Netzteil 23 und Laufwerke 24 bis 26 für die verschiedensten Informationsspeicher bereits eingesetzt sind. Die Frontplatte 8 ist nunmehr an den Kasten 12 kraft- und formschlüssig angebracht. Außerdem ist in Fig. 2 ein Frontblech 21 dargestellt, daß zum Frontabschluß des gesamten Chassis dient. In dem Frontblech 21 sind wiederum Luftein-/auslaßöffnungen 4 angeordnet und außerdem Durchbrüche 31 zum Einlegen von Informationsträgern angeordnet. Zur elektrischen Verbindung mit der Außenwelt ist außerdem die an der Hinterseite der Schublade bzw. des Schubkastens 12 angeordnete Übergabeplatine 19 dargestellt, die mit handelsüblichen bzw. speziellen Steckern bzw. Federleisten ausgeführt ist und an der das Kabel 30 mit Stecker angeordnet ist.

Außerdem ist in Fig. 2 das Oberteil 17 des Chassis dargestellt. Dieses Oberteil 17 besteht genauso wie das Unterteil 5 aus Kunststoff. Der Kunststoff kann beispielsweise expandierendes Polypropylen (EPP) sein. Dieses Material ist ansich bekannt und wird beispielsweise als Verpackungsmaterial verwendet. Zur Herstellung eines EPP-Chassis gemäß der vorliegenden Erfindung werden die folgenden Schritte durchgeführt:
Zunächst wird das Polypropylen-Granulat in einem bekannten Verfahren aufgeschäumt, um Polypropylen-Kügelchen zu bilden. Das Granulat beinhaltet Kohlenstoff, wodurch sichergestellt wird, daß der fertige Kunststoff eine elektrische Leitfähigkeit hat, die ausreichend ist, elektrostatische Aufladungen des Chassis zu vermeiden. Die Tropfen werden mit einem Druck von ungefähr 4 bar in die Form gespritzt, wobei die Form den gewünschten Strukturen des Chassis entspricht. Dieser Schritt führt zu einer Volumenverringerung. Im nachfolgenden Schritt wird Unterdruck angelegt, so daß das Volumen wieder anwächst und die Tropfen die Formgebung der Form annehmen. Dann wird heißer Wasserdampf mit ungefähr 180° Celsius eingeblasen, wodurch ein Zusammenwachsen der Tropfen an ihren Oberflächen (Kreuzvernetzung) bewirkt wird. Danach wird die Form geöffnet und das Schaumteil entnommen, das anschließend getempert wird.

Expandierendes Polypropylen hat mehrere vorteilhafte Eigenschaften, die es als Kunststoff für das hier vorgeschlagene Chassis geeignet machen. Beispielsweise hat es eine hohe Formstabilität, es ist dennoch nachgiebig und somit energieabsorbierend. Dies stellt eine stoßgeschützte Montage der Komponenten in dem Chassis sicher. Die Deformierbarkeit oder Nachgiebigkeit des Kunststoffes kann durch die Dichte des Materials beeinflußt werden. Bei einem praktischen Ausführungsbeispiel liegt die Dichte des Polypropylens in einem Bereich von ungefähr 60 bis 80 Gramm/Liter, was zu einer guten Formstabilität und gleichzeitig zu guten stoßabsorbierenden Eigenschaften führt. Der Dichtebereich von 20 bis 80 g/l kann für bestimmte Anwendungsfälle auch verwendet werden. Durch Ändern der Dichte können die Härte und die stoßabsorbierenden Eigenschaften an den jeweiligen speziellen Anwendungsfall angepaßt werden. Je kleiner die Dichte ist, um so weicher ist das Material, was zu verbesserten stoßabsorbierenden Eigenschaften führt. Ein anderer Vorteil von Polypropylen ist seine Temperaturstabilität, die wichtig ist, wenn die von dem Chassis getragenen Komponenten viel Wärme entwickeln. Man hat jedoch auch herausgefunden, daß während eines ununterbrochenen Betriebs die Temperatur der Komponenten in dem Chassis und dem Gerätegehäuse gemäß der Erfindung sogar etwas geringer ist als in einem herkömmlichen Gerät mit gleichen Komponenten. Der Grund dafür liegt darin, daß aufgrund der Luftkanäle, die in dem Chassis und zwischen dem Chassis und dem Schubkasten 12 geformt werden, ein gesteuerter und besser gerichteter Luftstrom erzeugt wird. Ein anderer Vorteil des Chassis aus Polypropylen besteht darin, daß es vollständig wiederverwertbar ist, da keine Metalle oder sonstigen Fremdmaterialien in ihm enthalten sind. Es sind jedoch auch andere Kunststoffe bekanntgeworden, die derartige vorteilhafte Eigenschaften besitzen. Derartige Materialien sind zum Beispiel Polyurethan oder Polyäthylen. Die Bezeichnung "Kunststoff", die hier verwendet wird, bezieht sich auf ein leichtes Material mit stoßabsorbierender Qualität und Formstabilität und ist bevorzugt ein synthetisches, formbares Material. Das Konzept des vorliegenden Gerätegehäuseaufbaus ist auch mit Materialien biologischen Ursprungs realisierbar.

Sollte ein brennbarer Kunststoff für das Chassis verwendet werden, dann kann ein Feuerschutz in Form einer Kohlendioxidkartusche innerhalb des Geräts vorgesehen werden. Die Kohlendioxidkartusche ist dann mit einem Wärmesensor gekoppelt, der die Temperatur überwacht und bewirkt, daß das Kohlendioxid abgegeben wird, wenn eine bestimmte Temperatur überschritten wird, so daß jegliches Feuer oder ein Schwelbrand gelöscht werden kann.

Das in Fig. 2 dargestellte Oberteil 17 des Chassis weist wie das Unterteil 5 integrierte nachgebende, jedoch formstabile Ohren 1 für den Toleranzausgleich und das Klemmen beim Einsatz in einer Schublade bzw. in den Schubkasten 12 auf. Auch hier werden wieder durch die Zwischenräume Lüftungskanäle 3 gebildet. In Fig. 2 ist auch ein Laufwerk 18 für einen nicht dargestellten Informationsträger zu sehen. Dieses Laufwerk 18 liegt zum Beispiel auf den Auflagen 13 auf, die zugleich Niederhalter für darunterliegende Laufwerke oder andere größere Komponenten sind. Von oben wird das Laufwerk 18 durch eine besonders ausgeführte Vorrichtung im Chassis festgehalten. Durch eine um eine Achse drehbar bzw. schwenkbar gelagerte Klappe 20, die in eine entsprechende Öffnung im Oberteil 17 des Chassis eingeklemmt oder gedrückt wird, wird das darunterliegende Laufwerk von oben sicher gehalten. Diese Klappe 20 besteht voll aus Kunststoff, vorzugsweise aus dem gleichen Kunststoff wie das Oberteil 17 und sie weist außer der integrierten Achse auch eine Lufteinlaß- bzw. -auslaßöffnung 4 und eine Griffmulde 22 auf.

Zur elektrischen Abschirmung wird das Ganze mit einem Abschirmblech 15 oder dergleichen von oben her abgedeckt, wobei das Abschirmblech 15 wiederum mit Lufteinlaß- bzw. -auslaßöffnungen 4 versehen ist. Die Befestigung des Abschirmbleches 15 kann entweder durch Schrauben, durch Clips oder durch Kleben bzw. andere Haltemittel erfolgen.

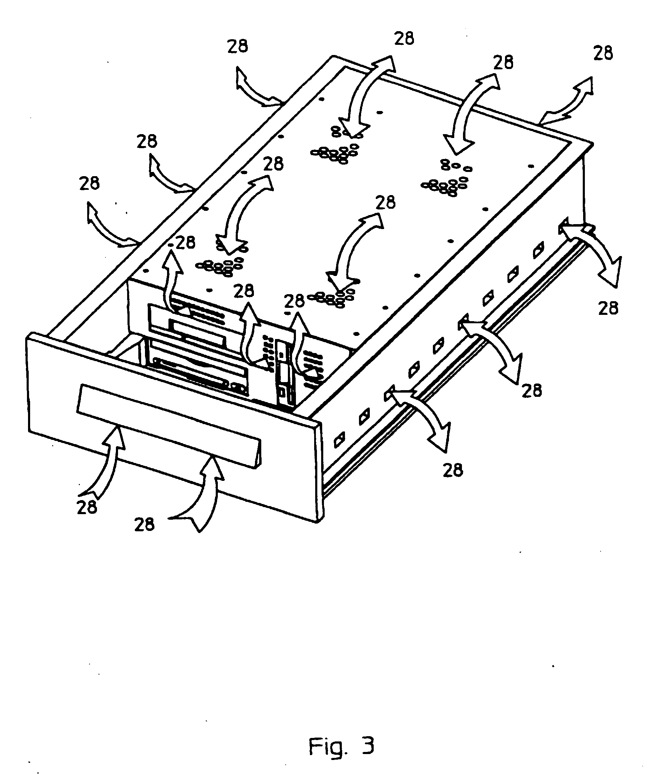

In Fig. 3 ist die eigentliche integrale Einheit der in den Figuren 1 und 2 dargestellten Komponenten und Teile zu einem kompletten Gerätegehäuse in Form eines Schubkastens bzw. einer Schublade dargestellt. Die Pfeile 28 sollen die Richtung für den jeweiligen Luftein- bzw. -austritt zeigen, wobei angemerkt werden soll, daß die Richtung durch die Frontplatte, wie gezeigt, vorteilhafterweise möglichst nur in der eingezeichneten Richtung erfolgen soll. Es ist außerdem vorteilhaft, wenn zwischen der Frontplatte des eigentlichen Schubkastens und der Frontplatte des Chassis ein freibleibender Raum 32 gebildet wird, der zum Einlegen zum Beispiel von Informationsträgern erforderlich ist bzw. der auch zum Ablegen von Informationsträgern geeignet ist. Zum besseren Einlegen können die Laufwerke auch in Schräglage eingebaut werden und zwar bis zu dem für die Laufwerke festgelegten Winkel.

Eine spezielle Variante für ein derartiges Gerätegehäuse besteht darin, daß die Schublade bzw. der Schubkasten 12 aus perforiertem Material besteht, wobei die Perforationen als Luftein- und -auslässe 4 für Luftkanäle dienen und der Luftstrom durch Schaumstoffeinlagen, die hinter der Perforation angeordnet sind oder nur teilweise in den Lüftungskanälen angeordnet sind, steuerbar ist.

Fig. 3 zeigt ganz deutlich, daß das Gerätegehäuse lediglich aus dem Schubkasten selbst und dem darin eingelegten ein-oder mehrteiligen Kunststoffchassis mit entsprechender Luftführung und Luftsteuerung gebildet wird. Die Luftführung bzw. die Luftsteuerung wird sowohl durch die Öffnungen im Kasten selbst als auch durch die beschriebene Ausbildung des Kunststoffchassis, das zusammen mit dem jeweiligen Kasten eine funktionelle Einheit bildet, erreicht.

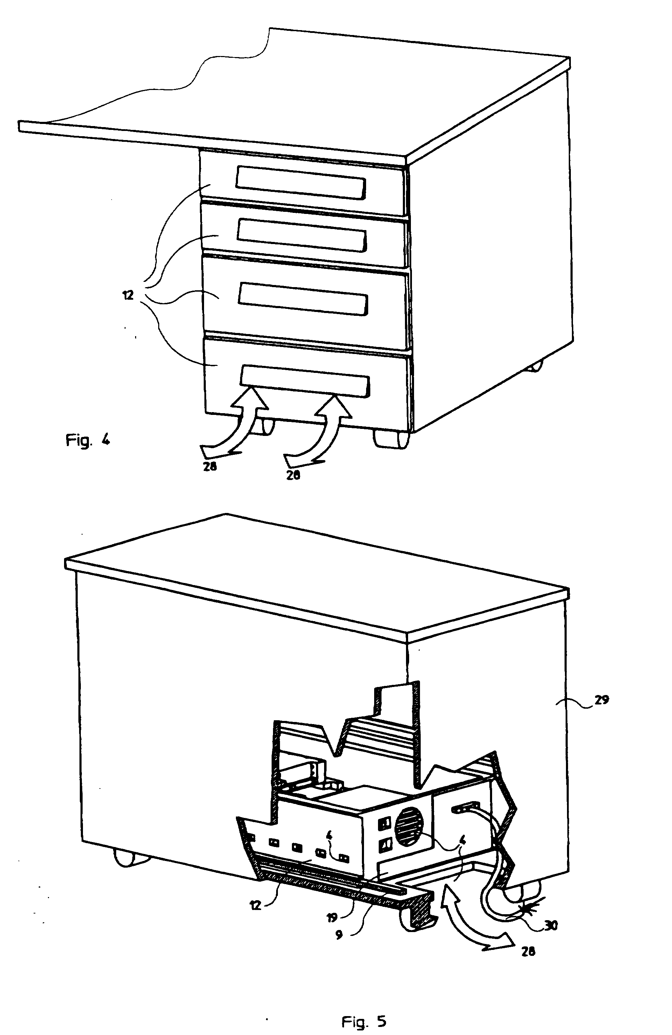

In Fig. 4 ist ein Seitenteil eines Schreibtisches zu sehen, in dem Schubladen bzw. Schubkästen 12 vorhanden sind. Wenn zum einen die Luftführung bzw. -strömung 28 durch den Griff der Schublade erfolgt und zum anderen wie in Fig. 5 zu sehen ist, die Hauptluftzufuhr bzw. -ableitung 28 hinten erfolgt, ist es sehr vorteilhaft, den unteren Kasten für die vorgeschlagene Anwendung zu verwenden. Aus Fig. 5 ist klar ein Rollschrank 29, zum Beispiel für einen Schreibtisch zu sehen, der rückseitig aufgebrochen dargestellt ist. Dadurch sind deutlich die Führungsschienen 9 für die Schublade 12 mit der Übergabeplatine 19 und dem Kabel 30 mit Stecker zu sehen. Aus dieser Figur wird auch nocheinmal klar die Luftströmung bzw. die Luftführung durch die Luftein- bzw. -auslaßöffnungen 4 im eingebauten Zustand ersichtlich. Als Möbel sind jegliche kommerziell verwendbaren und Wohnraummöbel geeignet, die mit Schubladen, insbesondere mit Metallschubläden bzw. -schubkästen ausgeführt sind. Es soll hier nochmals betont werden, daß das in den Figuren 1 bis 5 dargestellte Gerätegehäuse mit jeder Art von Komponenten bestückt werden kann, die nicht notwendigerweise elektrischer oder elektromechanischer Natur sein müssen. Beispielsweise können auch optische Komponenten oder nur mechanische Komponeten in dem Chassis angeordnet sein. Die erfindungsgemäße Anordnung kann also nicht nur bei Computern oder ähnlichen datenverarbeitenden Geräten verwendet werden, sondern bei sehr vielen unterschiedlichen Arten von Geräten, wie zum Beispiel Multimediageräten oder Fernsehgeräten. Beispielsweise kann diese Anordnung jedoch auch bei elektronischen Geräten oder Instrumenten verwendet werden, wie zum Beispiel Signalgebern und Test- und Meßgeräten, wie Oszillographen, Spektralanalysatoren, Multimetern und bei Geräten der Medizintechnik. Ein anderes Einsatzgebiet ist das von Geräten für die analytische Chemie. Ein erfindungsgemäßes Gerätegehäuse kann zum Beispiel in Flüssigkeits-Cromatographen verwendet werden, um dessen Komponenten, wie Pumpen, Spritzen, Ventile, Steuer- und Datenverarbeitungseinheiten und den Detektor zu tragen. Die Kanäle für die Flüssigkeiten können in dem Chassismaterial bei dem Formpreßvorgang ausgebildet werden, so daß keine Leitungen wie in herkömmlichen Cromatographen erforderlich sind. Das erfindungsgemäße Gerätegehäuse ist ein sehr leichtes, stoßabsorbierendes Gehäuse, das einfach herzustellen ist und eine einfache Montage der Einzelteile gewährleistet. Genauso einfach wie die Montage ist die Demontage eines derartigen Gerätes, was beim Reparieren des Gerätes sehr vorteilhaft ist. Eine derartige Demontage wird einfach durch Herausnehmen des Oberteils des Chassis oder des gesamten Chassis aus dem Schubkasten bzw. der Schublade bewerkstelligt. Außer zum Öffnen eventuell eines Verschlusses des Chassis ist hierzu kein Werkzeug und schon gar nicht Spezialwerkzeug erforderlich.

### Liste der Bezugszeichen

- 1: Ohren
- 2: Bedienungs- und Ablageraum
- 3: Luftführungskanäle
- 4: Luftein- und -auslaß
- 5: Schaumstoffunterteil
- 6: Arretierungsdome und Abstandshalter
- 7: Arretierungslöcher für Schaumstoffteil
- 8: Frontblende für Schublade
- 9: Führungsschiene für Schublade
- 10: Raum für Lufteinlaß/-auslaß
- 11: Steckkarteneinschub
- 12: Schublade/Schubkasten
- 13: Auflagen und Niederhalter
- 14: Schaumstoffteile zur Luftstromsteuerung
- 15: Abschirmblech
- 16: Schrauben/Clipse
- 17: Schaumstoffoberteil
- 18: Laufwerk
- 19: Übergabeplatine
- 20: Schaumstoffklappe
- 21: Frontblech
- 22: Griffmulde
- 23: Netzteil
- 24, 25, 26: Laufwerke
- 27: Leiterplatte mit Bauteilen
- 28: Luftein-/austrittströmung (Schublade)
- 29: Rollschrank
- 30: Kabel mit Stecker
- 31: Durchbrüche zum Einlegen von Infoträgern
- 32: Griff

## Patentansprüche

1. Gerätegehäuse für elektrische, elektronische, feinmechanische, mechanische oder sonstige Geräte zur Unterbringung in Möbeln mit Schubladen bzw. -kästen, dadurch gekennzeichnet,
daß, das Gerätegehäuse als die Schublade bzw. der Schubkasten (12) aus Metall, einem metallisierten oder mit Metall ausgekleideten Werkstoff mit einem Kunststoffchassis bzw. -komponententräger zur Aufnahme von Gerätekomponenten eine funktionale und integrale Einheit bildet und
daß Luftein-/auslaßöffnungen (4) sowie am Chassis angeordnete Ohren (1) und Arretierungsdome bzw. Abstandshalter (6) zusammen mit den Wänden, dem Boden der Schublade bzw. des -kastens (12) und gegebenenfalls mit einem oberen Abschirmblech (15) Luftführungskanäle (3) für Be- und Entlüftung bilden.

2. Gerätegehäuse nach dem Oberbegriff des Patentanspruches 1, dadurch gekennzeichnet,
daß Luftführungskanäle (3), die vom Boden, von der Abdeckung und/oder den Seitenwänden eines Schubkastens bzw. einer Schublade (12) und Räumen zwischen einem eingelegten Kunststoffchassis, das aus einem Teil oder mindestens zwei Teilen (5, 17) besteht und mit Ohren (1) und mit Arretierungsdomen bzw. Abstandshaltern (6) versehen ist, gebildet werden, wobei die Böden bzw. Wände und Abdeckungen mit Luftein-/ bzw. - auslaßöffnungen (4) unterschiedlicher Größe und unterschiedlicher Form ausgestattet sind und
daß die Luftführungskanäle (3) mit einsteckbaren, einschiebbaren oder verschiebbaren bzw. verstellbaren Kunststoffteilen (14) steuerbar ausgebildet sind.

3. Gerätegehäuse nach Patentanspruch 2, dadurch gekennzeichnet,
daß die Kunststoffteile (14) zur Luftstromsteuerung modular einsetzbar ausgebildet sind.

4. Gerätegehäuse nach einem der Patentansprüche 1 bis 3, dadurch gekennzeichnet,
daß die Schublade bzw. der Schubkasten (12) und gegebenenfalls ein Abschirmblech (15) oder metallisiertes Abschirmteil aus perforiertem Material bestehen und
daß die Luftführungskanäle (3) durch Schaumstoffeinlagen steuerbar ausgebildet sind.

5. Gerätegehäuse nach einem der Patentansprüche 1 bis 4, dadurch gekennzeichnet,
daß am Unterteil (5) des Chassis integrierte Auflagen und Niederhalter (13) für Laufwerke (18 und 26) angeordnet sind und
daß im Oberteil (17) des Chassis eine klemmbar ausgestaltete Schaumstoffklappe (20) zum Verriegeln und Halten der darunterliegenden Laufwerke klappbar bzw. drehbar angeordnet ist.

6. Gerätegehäuse nach einem der Patentansprüche 1 bis 5, dadurch gekennzeichnet,
daß das mit dem Schubkasten bzw. mit der Schublade (12) lösbar verbundene Chassis (zum Beispiel 5 und 17) an der Frontseite durch ein Frontblech (21) mit vertikalen und horizontalen Durchbrüchen (31) zum Einlegen von Informationsträgern und mit Lüftungsöffnungen (4) abgeschlossen ist und
daß die Oberseite des Chassis mit einem Abschirmblech (15) mit Lüftungsöffnungen (4) abgeschlossen ist.

7. Gerätegehäuse nach einem der Patentansprüche 1 bis 5, dadurch gekennzeichnet,
daß die Ohren (1) zum Toleranzausgleich, Halten und Klemmen des Kunststoffchassis in der Schublade bzw. im Schubkasten (12) ballig, keilförmig oder doppelkeilförmig aus dem gleichen Material wie das Chassis als integraler Bestandteil des Chassis ausgeformt sind.

8. Gerätegehäuse nach einem der Patentansprüche 1 bis 7, dadurch gekennzeichnet,
daß am hinteren Teil des Schubkastens bzw. der Schublade (12) eine Übergabeplatine (19) für elektrische Anschlüsse angeordnet ist und
daß zwischen der Frontseite des Schubkastens bzw. der Schublade (12) und dem Frontblech (21) des Chassis ein Bedienungs- und Ablageraum (2), zum Beispiel für die Datenträger ausgebildet ist.

9. Gerätegehäuse nach einem der Patentansprüche 1 bis 6, dadurch gekennzeichnet,
daß die Luftein- und -auslaßöffnungen (4) für den Luftein- und -austritt rechteckig, quadratisch, rund, schlitzförmig oder elliptisch geformt sind.

10. Gerätegehäuse nach einem der Patentansprüche 1 bis 8, dadurch gekennzeichnet,
daß es integraler Bestandteil von Büromöbeln, insbesondere Schreibtischen, Labormöbeln, Heimmöbeln oder Werkstattmöbeln ist und vorzugsweise als untere Schublade oder unterer Schubkasten (12) angeordnet ist und
daß der Griff (32) zur Luftführung ausgebildet ist.

11. Gerätegehäuse nach Patentanspruch 10, dadurch gekennzeichnet,
daß in ihm Komponenten von Computern, Multimediageräten, Video- und Radiogeräten, Steuer-, Meß- und Überwachungsgeräten und/oder Nachrichtenvermittlungs- und Übermittlungsgeräten angeordnet sind.

12. Gerätegehäuse nach einem der Patentansprüche 1 bis 11, dadurch gekennzeichnet,
daß Luftführungskanäle (3) zwischen den Wänden und dem Boden der Schublade bzw. des Schubkastens (12) und den Außenwänden bzw. dem -boden des Chassis mit integrierten Ohren (1) zum Halten und Klemmen des Chassis und innerhalb des Chassis ausgeformt sind.

13. Gerätegehäuse nach einem der Patentansprüche 1 bis 12, dadurch gekennzeichnet,
daß das aus mindestens einem Oberteil (17) und einem Unterteil (5) bestehende Chassis integrierte Auflagen und Niederhalter sowie klapp- bzw. schwenkbare Niederhalter (20) zum Verriegeln und Festhalten von Komponenten in einer, zwei oder mehreren Ebenen enthält.

14. Gerätegehäuse nach Patentanspruch 13, dadurch gekennzeichnet,
daß die Teile (5, 17) des Chassis, die Schaumstoffteile (14) zur Luftstromsteuerung und die Schaumstoffklappe (20) zum Verriegeln und Halten der Laufwerke oder größerer Komponenten aus dem gleichen Kunststoff durch Formpressen hergestellt sind.

15. Gerätegehäuse nach einem der Patentansprüche 1 bis 14, dadurch gekennzeichnet,
daß die Teile (5, 17) des Chassis aus Kunststoff mit einer Dichte von annähernd 60 bis 80 Gramm/Liter bestehen.

16. Gerätegehäuse nach einem der Patentansprüche 1 bis 15, dadurch gekennzeichnet,
daß der Kunststoff expandierendes Polypropylen ist.

17. Gerätegehäuse nach einem der Patentansprüche 1 bis 16, dadurch gekennzeichnet,
daß der Kunststoff Polyurethan oder expandiertes Polyäthylen ist.

18. Gerätegehäuse nach einem der Patentansprüche 1 bis 16, dadurch gekennzeichnet,
daß die Schublade bzw. der -kasten (12) mit dem Kunststoffchassis das Gerätegehäuse mit Luftführung und -kanälen bildet, und
daß die Abschirm- und Abdeck- bzw. Frontplatten (8, 15, 21 und/oder 30) mittels Schnappverbindung, Schrauben, Clipsen (16) oder mittels einer im wesentlichen formschlüssigen Verbindung gehalten sind.

19. Gerätegehäuse nach einem der Patentansprüche 1 bis 18, dadurch gekennzeichnet,
daß das aus mindestens zwei Teilen (5, 17) bestehende Chassis in eine Metallfolie oder eine metallisierte elektrisch leitende Folie komplett eingewickelt ist und daß
diese Folie Lüftungsein- und -auslaßöffnungen (4) an den hierzu erforderlichen Stellen aufweist.

20. Gerätegehäuse nach Patentanspruch 19, dadurch gekennzeichnet,
daß die Folie zum Einwickeln für jedes abnehmbare Teil, wie zum Beispiel des Unterteils (5) und des Oberteils (17), getrennt ausgebildet ist.

## Claims

1. A device housing for electrical, electronic, precision mechanical, mechanical or other devices to be stored in furniture with drawers, characterized in that
the device housing forms a functional and integral unit as a drawer (12) made of metal, a metallized material or material coated with metal with a plastic chassis or component carrier to receive device components, and
air channelling ducts (3) for ventilation are formed by air inlets/outlets (4) as well as projections (1) in the chassis and catches or spacers (6) together with the walls, the floor of the drawer (12) and possibly with a top shielding plate (15).

2. A device housing according to the preamble of patent claim 1, characterized in that
the air channelling ducts (3) are formed by the floor, the cover and/or the side walls of a drawer (12) and gaps between an inserted plastic chassis that consists of one or at least two parts (5, 17) and is provided with projections (1) and catches or spacers (6), whereby the floor or walls and covers are provided with air inlets or outlets (4) of different sizes and shapes, and
the air channelling ducts (3) can be controlled with pluggable, insertable, or movable or adjustable plastic parts (14).

3. A device housing according to patent claim 2, characterized in that
the plastic parts (14) are insertable modules to control air flow.

4. A device housing according to one of patent claims 1-3, characterized in that
the drawer (21) and possibly a screening plate (15) or metallized screen consists of perforated material, and
the air channelling ducts (3) are controlled by foam inserts.

5. A device housing according to one of patent claims 1-4, characterized in that
integrated seats and top grips (13) for disk drives (18,26) are on the bottom part (5) of the chassis, and
there is a clampable foam flap (20) to lock and hold the disk drive underneath that is hinged to the top (17) of the chassis.

6. A device housing according to one of patent claims 1-5, characterized in that
the chassis (e.g. 5 and 17) releasably connected to the drawer (12) is closed at the front by a front panel (21) with vertical and horizontal penetrations (31) to insert information carriers and with ventilation holes (4),
and the top of the chassis is closed with a screening plate (15) with ventilation holes (4).

7. A device housing according to one of patent claims 1-5, characterized in that
the projections (1) to compensate for tolerances, hold and clamp the plastic chassis in the drawer (12) are convex, wedge-shaped, or double-wedge-shaped and made of the same material as the chassis as an integral component of the chassis.

8. A device housing according to one of patent claims 1-7, characterized in that
there is a interconnecting panel (19) for electrical connections on the rear of the drawer (12), and
there is a service or storage area (2), e.g. for data carriers, between the front of the drawer (12) and front panel (21) of the chassis.

9. A device housing according to one of patent claims 1-6, characterized in that
air inlets and outlets (4) for ventilation are rectangular, square, round, slotted or elliptical.

10. A device housing according to one of patent claims 1-8, characterized in that
it is an integral component of office furniture, especially desks, laboratory furniture, home furniture, or shop furniture and it is preferably a bottom drawer (12),
and the handle (32) is designed to conduct air.

11. A device housing according to patent claim 10, characterized in that
there are components in the housing of computers, multimedia devices, video and radio devices, control, measuring and monitoring devices and/or message switching and communication devices.

12. A device housing according to one of patent claims 1-11, characterized in that
the air channelling ducts (3) between the walls and the floor of the drawer (12) and the outer walls and floor of the chassis are formed by projections (1) to hold and clamp the chassis, and they are formed inside the chassis.

13. A device housing according to one of patent claims 1-12, characterized in that
the chassis consisting of at least one top part (17) and a bottom part (5) has integrated seats and top grips (20) to lock and hold components in one, two, or more planes.

14. A device housing according to patent claim 13, characterized in that
the parts (5, 17) of the chassis, the foam parts (14) for controlling air flow and the foam flap (20) to lock and hold the disk drive or larger components are manufactured out of the same plastic by compression molding.

15. A device housing according to one of patents claims 1-14, characterized in that
the parts (5,17) of the chassis are made of plastic with a density of approximately 60-80 g/l.

16. A device housing according to one of patent claims 1-15, characterized in that
the plastic is expanded polypropylene.

17. A device housing according to one of patent claims 1-16, characterized in that
the plastic is polyurethane or expanded polyethylene.

18. A device housing according to one of patent claims 1-16, characterized in that
the drawer (12) with the plastic chassis forms the device housing with air circulation and channels, and
the screening plate, cover plate and front plate (8, 15, 21 and/or 30) are held by snap connections, screws, clips (16) or with an essentially positive fit.

19. A device housing according to one of patent claims 1-18, characterized in that
the chassis consisting of at least two parts (5,17) is completely wrapped in a metal foil or metallized, electrically conductive foil, and
the foil has air inlets and outlets (4) at the necessary sites.

20. A device housing according to patent claim 19, characterized in that
wrapping foil is designed separately for each removable part such as the bottom part (5) and the top part (17).

## Revendications

1. Un boîtier d'appareillage destiné à intégrer des appareils électriques, électroniques, de mécanique de précision, de mécanique ou d'autres appareils, dans des meubles équipés de tiroirs ou de casiers, ce boîtier est caractérisé par le fait que :
le tiroir ou casier à glissières (12) du boîtier d'appareillage est constitué d'un matériau métallisé ou habillé d'un revêtement métallique, et forme avec un châssis en matériau synthétique ou support de composants, destiné à recevoir des composants d'appareil, une unité fonctionnelle et intégrale, et
par le fait que des orifices d'entrée / de sortie d'air (4), des oreilles (1) intégrées au châssis, des bossoirs d'arrêt ou entretoises (6) forment ensemble avec les parois, le fond du tiroir ou du casier à glissières (12), et éventuellement avec une plaque de fermeture supérieure de blindage (15), des canaux de circulation d'air (3) pour la ventilation ou l'aération.

2. Un boîtier d'appareillage conforme à la définition générale de la revendication d'invention 1, et caractérisé par le fait que :
les canaux de ventilation (3) sont constitués par le fond du boîtier, par le couvercle et/ou les parois du tiroir ou d'un casier à glissières (12) et les espaces formés par l'introduction d'un châssis en matériau synthétique composé d'une seule pièce ou d'au moins deux pièces (5, 17) et équipé d'oreilles (1) et de bossoirs d'arrêt ou entretoises (6), dans ce montage les fonds, les parois et les couvercles sont équipés d'orifices d'entrée / de sortie d'air (4) de différentes tailles et de différentes formes, et par le fait que la forme des canaux de circulation d'air (3) est variable par l'intermédiaire de pièces en matière synthétique (14) qui peuvent être encliquetées, enfichées ou déplacées.

3. Un boîtier d'appareillage conforme à la revendication d'invention 2, et caractérisé par le fait que :
les pièces en matière synthétique (14) servant à l'orientation du circuit d'air sont constituées de modules pouvant être agencés.

4. Un boîtier d'appareillage conforme à une des revendications d'invention 1 à 3, et caractérisé par le fait que :
le tiroir ou casier à glissières (12), et si nécessaire une plaque de blindage (15) ou une pièce de blindage métallisée, sont constitués d'un matériau perforé, et que
les canaux de circulation d'air (3) ont une forme variable grâce à des pièces en mousse.

5. Un boîtier d'appareillage conforme à une des revendications d'invention 1 à 4, et caractérisé par le fait que :
la partie inférieure (5) du châssis comporte des pièces de support et de maintien (13) pour des lecteurs de médias électroniques (18 et 26), et que
la partie supérieure (17) du châssis comporte un clapet encastrable et pivotant en mousse (20) qui sert au verrouillage et au maintien des lecteurs situés en dessous.

6. Un boîtier d'appareillage conforme à une des revendications d'invention 1 à 5, et caractérisé par le fait que :
le châssis démontable et amovible (par exemple 5 et 17) relié au tiroir ou casier à glissières (12) est fermé sur sa face avant par une plaque frontale en tôle (21) comportant des ouvertures horizontales et verticales (31), devant permettre l'introduction de médias électroniques et le passage de l'air, et que
la partie supérieure du châssis est fermée par une tôle de blindage (15) comportant des ouvertures de circulation d'air (4).

7. Un boîtier d'appareillage conforme à une des revendications d'invention 1 à 5, et caractérisé par le fait que :
les oreilles (1), destinées à compenser les tolérances dimensionnelles, maintenir et bloquer le châssis en matière synthétique dans le tiroir ou casier à glissières (12), possèdent une forme bombée, une forme de cale ou de cale double et sont constituées du même matériau que celui du châssis et font partie intégrante de ce dernier.

8. Un boîtier d'appareillage conforme à une des revendications d'invention 1 à 7, et caractérisé par le fait que :
la face arrière du tiroir ou casier à glissières (12) comporte une platine de transmission (19) destinée à recevoir les raccordements électriques, et que
la partie située entre la face avant du tiroir ou casier à glissières (12) et la plaque frontale en tôle (21) du châssis, est réalisée sous la forme d'un espace de commande ou de rangement (2), par exemple pour les médias électroniques.

9. Un boîtier d'appareillage conforme à une des revendications d'invention 1 à 6, et caractérisé par le fait que :
les ouvertures de circulation d'air (4), pour l'entrée / la sortie de l'air, possèdent une forme carrée, rectangulaire, ronde, fendue ou elliptique.

10. Un boîtier d'appareillage conforme à une des revendications d'invention 1 à 8, et caractérisé par le fait :
qu'il fait partie intégrante de meubles de bureau, en particulier de bureaux, de meubles de laboratoires, de meubles de maison ou de meubles d'atelier, et qu'il constitue de préférence le tiroir ou casier à glissière (12) inférieur de ces meubles, et que l'orifice d'ouverture (32) est adapté à la circulation d'air.

11. Un boîtier d'appareillage conforme à la revendication d'invention 10, et caractérisé par le fait :
qu'il contient des composants d'ordinateurs, des appareils multimédia, des appareils vidéo ou radio, des appareils de commande, de mesure ou de contrôle et/ou des appareils récepteur ou transmetteurs d'informations.

12. Un boîtier d'appareillage conforme à une des revendications d'invention 1 à 11, et caractérisé par le fait que :
les canaux de circulation d'air (3), entre les parois et le fond du tiroir ou casier à glissière (12), et entre les parois externes ou le fond externe du châssis, comportent des oreilles (1) qui servent à maintenir et à bloquer le châssis et font partie intégrante de ce dernier.

13. Un boîtier d'appareillage conforme à une des revendications d'invention 1 à 12, et caractérisé par le fait que :
le châssis formé d'au moins une partie supérieure (17) et d'une partie inférieure (5), comporte des pièces de support et de maintien intégrées, ainsi que des pièces de maintien rabattantes ou pivotantes (20), pour le verrouillage et le serrage de composants sur un, deux ou plusieurs niveaux.

14. Un boîtier d'appareillage conforme à la revendication d'invention 13, et caractérisé par le fait que :
les pièces (5, 17) du châssis, les pièces en mousse (14) d'orientation du circuit d'air et le clapet en mousse (20) de verrouillage et de maintien des lecteurs de médias ou de composants plus grands, sont constitués du même matériau synthétique formé par pressage.

15. Un boîtier d'appareillage conforme à une des revendications d'invention 1 à 14, et caractérisé par le fait que :
les pièces (5, 17) du châssis sont constituées d'un matériau synthétique dont la densité est d'environ 60 à 80 grammes/litre.

16. Un boîtier d'appareillage conforme à une des revendications d'invention 1 à 15, et caractérisé par le fait que :
la matière synthétique est du polypropylène expansé

17. Un boîtier d'appareillage conforme à une des revendications d'invention 1 à 16, et caractérisé par le fait que :
la matière synthétique est du polyuréthanne ou du polypropylène expansé

18. Un boîtier d'appareillage conforme à une des revendications d'invention 1 à 16, et caractérisé par le fait que :
le tiroir ou casier à glissière (12) constitue avec le châssis en matière synthétique le boîtier d'appareillage avec un circuit d'orientation et des canaux de circulation d'air, et que
les tôles de blindage et de fermeture ou de la face frontale (8, 15, 21 et/ou 30) sont fixées par vis, par agrafes (16) ou au moyen d'une liaison par emboîtement de formes.

19. Un boîtier d'appareillage conforme à une des revendications d'invention 1 à 18, et caractérisé par le fait que :
le châssis constitué au moins de deux parties (5, 17) est enfermé complètement dans une feuille métallique ou une feuille métallisée conductrice de courant, et que
cette feuille comporte aux emplacements correspondants les ouvertures indispensables pour les entrées et sorties d'air (4).

20. Un boîtier d'appareillage conforme à la revendication d'invention 19, et caractérisé par le fait que :
la feuille d'enveloppe est composée de parties séparées pour les différentes parties amovibles, comme par exemple la partie inférieure (5) et la partie supérieure (17).
